Europäisches Patentamt

European Patent Office

Office européen des brevets

(11) Veröffentlichungsnummer: **0 009 649**
**B1**

(12) **EUROPÄISCHE PATENTSCHRIFT**

(45) Veröffentlichungstag der Patentschrift:
14.10.81

(21) Anmeldenummer: 79103300.4

(22) Anmeldetag: 05.09.79

(51) Int. Cl.³: **G 01 R 19/165,** G 01 R 17/00,
B 60 L 1/12

(54) Schaltung zur Überwachung von Schaltzuständen.

(30) Priorität: 02.10.78 DE 2842966

(43) Veröffentlichungstag der Anmeldung:
16.04.80 Patentblatt 80/8

(45) Bekanntmachung des Hinweises auf die Patenterteilung:
14.10.81 Patentblatt 81/41

(84) Benannte Vertragsstaaten:
AT BE CH FR IT

(56) Entgegenhaltungen:
DE-A1-2 501 388
FR-A-1 378 320
GB-A-1 249 426
GB-A-1 273 428
GB-A-1 455 352
US-A-3 341 816

(73) Patentinhaber: **Schaltbau Gesellschaft mbH,**
**Hohenwaldeckstrasse 1, D-8000 München 90 (DE)**

(72) Erfinder: **Baumann, Josef, Robert-Koch-Strasse 24,**
**D-8025 Unterhaching (DE)**
Erfinder: **Meissl, Robert, Spechtstrasse 17,**
**D-8031 Eichenau (DE)**

(74) Vertreter: **Schneider, Wilhelm,**
**Kabelkamp 20 Postfach 260, D-3000 Hannover 1 (DE)**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

BUNDESDRUCKEREI BERLIN

Schaltung zur Überwachung von Schaltzuständen

Gegenstand der Erfindung ist eine Schaltung, die geeignet ist, den Schaltzustand anderer Schaltungen zu überwachen, die nach zwei oder mehreren Parametern unterschiedliche Schaltzustände einnehmen.

Es sind in der Technik Schaltungen bekannt, die veränderbar sind und nach zwei oder mehreren Parametern unterschiedliche Schaltzustände einnehmen können. Solche Schaltungen gibt es z. B. in der Beheizung oder sonstigen Versorgung von Eisenbahnwagen auf elektrifizierten Strecken im grenzüberschreitenden Verkehr. Die Speisespannungen, die aus den Eisenbahnnetzen zugeführt werden, liegen gewöhnlich bei 1000 oder 1500 oder 3000 Volt. Darüber hinaus werden die 1000-Volt-Netze mit einem Wechselstrom mit einer Frequenz von $16^2/3$ Hz beschickt, während für die 1500-Volt-Netze sowohl Gleichstrom als auch Wechselstrom von 50 Hz bekannt sind. Die 3000-Volt Netze arbeiten mit Gleichstrom. Es sind zahlreiche Schaltungen bekannt, die ein automatisches Umschalten von jeweils sechs Heizelementen auf die drei unterschiedlichen Spannungshöhen ermöglichen. Eine solche Schaltung ist in der DE-OS 2 501 388 angegeben. Darüber hinaus müssen aus diesen Netzen aber noch andere Verbraucher versorgt werden, die entweder nur Wechselstrom oder nur Gleichstrom aufnehmen und die zum Teil induktive Lasten darstellen. Hier sind zusätzliche Umschaltvorrichtungen erforderlich. Wegen der teilweise recht hohen aufgenommenen Leistungen und dem damit verbundenen Sicherheitsrisiko ist es erforderlich, zu prüfen, ob die beim Übergang von einem Netz auf das andere automatisch tätigen Umgruppierungsvorrichtungen zuverlässig arbeiten und gegebenenfalls die anstehende Netzspannung abschalten.

Der vorliegenden Erfindung liegt die Aufgabe zugrunde, eine Schaltung anzugeben, die die Schaltzustände solcher für mehrere Spannungen oder auch unterschiedliche Lasten ausgelegte Schaltungen überprüft.

Die Verwendung von paarweise betriebenen Operationsverstärkern ist bekannt. So wird nach der GB-PS 1 455 352 eine Temperaturkontrolle derart ausgeführt, daß die Temperatur den Wert eines temperaturabhängigen Widerstandes in einer Meßbrücke einstellt und die dabei gegebenenfalls an der Meßbrücke auftretenden Verschiebungen über zwei Operationsverstärker zum mechanischen Antrieb eines Stellgliedes für die Temperatur verwendet werden.

Aus der GB-PS 1 273 428 ist es bekannt, die Amplitude eines Wechselstromes dadurch zu überwachen, daß die an einem von dem Wechselstrom durchflossenen Spannungsteiler abfallenden Spannungen in zwei Operationsverstärkern mit einem Normalwert verglichen wird und je nach dem Vergleichsergebnis das Einhalten oder Überschreiten eines gewissen Bereiches angezeigt wird.

In beiden Fällen handelt es sich lediglich um die Prüfung der Einhaltung eines gewissen vorgegebenen Meßbereiches, nicht aber um die Überwachung von durch zwei oder mehrere Parameter bedingten Schaltzuständen einer Schaltung wie eingangs dargelegt.

Gegenstand der vorliegenden Erfindung ist eine Schaltung zum Überwachen des Zustandes einer elektrischen Schaltung, die nach zwei oder mehreren Parametern in mehrere diskrete Schaltungszustände überführt werden kann. Die Erfindung wird darin gesehen, daß in der erfindungsgemäßen Schaltung mit Hilfe eines Spannungsteilers zwei feste Referenzspannungen erzeugt werden, für jeden diskreten Schaltzustand nach dem ersten Parameter eine für jeden Schaltzustand gleiche Meßspannung über einen für jeden Schaltzustand gesonderten, sonst aber gleichen ersten Eingangswiderstand, eine erste Diode und einen für alle Schaltzustände gemeinsamen Prüfwiderstand geführt wird, die über dem Prüfwiderstand abfallende und in der Höhe zwischen den Referenzspannungen liegende Meßspannung in einem Komparator mit den Referenzspannungen verglichen wird, der bei Über- bzw. Unterschreiten einer der Referenzspannungen ein Signal auslöst, und daß für den zweiten und jeden weiteren für den diskreten Schaltzustand maßgeblichen Parameter jedem ersten Eingangswiderstand ein zweiter Eingangswiderstand über eine zweite Diode parallel geschaltet ist und Mittel vorgesehen sind, die bei ordnungsgemäßem Anstehen der Parameter eine Ableitung des über den zweiten Eingangswiderstand geführten Teiles der Meßspannung bewirken.

Der besondere Vorteil der erfindungsgemäßen Schaltung ist darin zu sehen, daß sie aus relativ billigen verschleißfesten Bauteilen aufgebaut ist und gegebenenfalls nur ein Bauteil mit mechanisch bewegten Teilen zum etwaigen Abschalten eines Stromkreises infolge des abgegebenen Signals verwendet werden muß.

In Weiterbildung der Erfindung besteht der zum Vergleichen der Prüfspannung mit den Referenzspannungen verwendete Komparator aus zwei Operationsverstärkern. Die höhere Referenzspannung wird dem invertierenden Eingang des ersten Operationsverstärkers und die niedrigere Referenzspannung dem nicht invertierenden Eingang des zweiten Operationsverstärkers zugeführt, während die Meßspannung an den verbleibenden Eingängen angelegt wird. Bei entsprechender Über- bzw. Unterschreitung einer der Referenzspannungen weisen die Ausgänge der Operationsverstärker eine Polarisierung auf, die in einer nachfolgenden Auswertschaltung das Signal auslöst.

Die Überwachung des Anstehens eines zweiten und gegebenenfalls weiterer Parameter erfolgt mit besonderem Vorteil dadurch, daß die Mittel zur Ableitung des über den zweiten Eingangswiderstand geführten Teiles der Meß-spannung aus zwei weiteren Operationsverstär-kern bestehen. Eine stabilisierte positive Grundspannung wird an dem nicht invertierenden Eingang des ersten Operationsverstärkers und an den invertierenden Eingang des zweiten weiteren Operationsverstärkers gelegt. An den verbleibenden Eingängen liegt eine Spannung, die bei Anstehen eines Parameters negativer als die Grundspannung und bei Fehler dieses Parameters oder Anstehen eines dazu alternativen Parameters positiver als die Grundspannung ist.

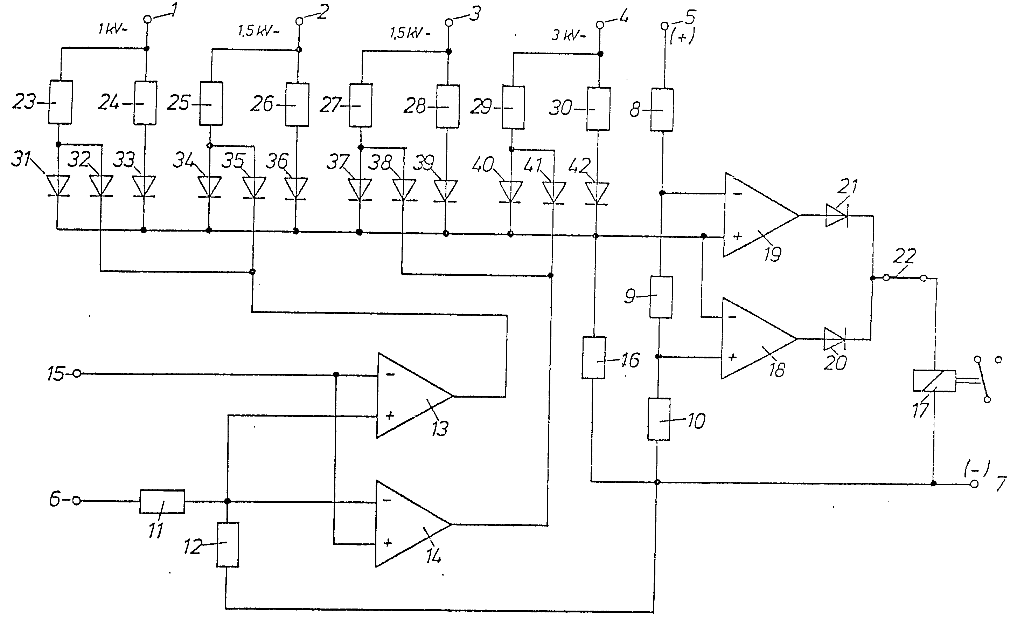

Die Figur zeigt in zum Teil schematischer Darstellung ein Ausführungsbeispiel einer Schaltung nach der Erfindung, das zur Überwachung des Schaltzustandes einer Mehrspannungswähleinrichtung in Reisezugwaren im internationalen Zugverkehr verwendet werden kann.

Für jeden Schaltzustand — 1000 Volt Wechselstrom, 1500 Volt Wechselstrom, 1500 Volt Gleichstrom und 3000 Volt Gleichstrom — ist ein gesonderter Eingang 1 bis 4 vorgesehen, an dem eine von der Mehrspannungswähleinrichtung aufgeschaltete positive Meßspannung von stets gleicher Höhe ansteht. Diese Meßspannung wird über einen der Widerstände 24, 26, 28, 30 und über einer dazu gehörigen Diode 33, 36, 39, 42 sowie über den Prüfwiderstand 16 zum Minuspol der Gleichspannung bei 7 geführt. Die gleiche Meßspannung steht bei 5 an dem aus den Widerständen 8, 9 und 10 bestehenden Spannungsteiler an. Über dessen Widerstand 9 wird eine hohe Referenzspannung dem invertierenden Eingang − des Operationsverstärkers 19 zugeführt und eine niedrigere Referenzspannung dem nicht invertierenden Eingang + des Operationsverstärkers 18. Die am Prüfwiderstand 16 abfallende Spannung steht am nicht invertierenden Eingang + des Operationsverstärkers 19 und am invertierenden Eingang − des Operationsverstärkers 18 an. An dem aus den Widerständen 11 und 12 bestehenden Spannungsteiler liegt bei 6 gegen den Minuspol 7 eine stabilisierte positive Spannung an. Zwischen 11 und 12 wird eine positve Grundspannung abgegriffen und dem nicht invertierenden Eingang + des Operationsverstärkers 13 sowie dem invertierenden Eingang − des Operationsverstärkers 14 zugeführt. Bei 15 liegt eine Spannung an, die von der Stromart abhängig ist und die bei Anstehen von Gleichstrom negativer, bei Anstehen von Wechselstrom jedoch positiver als die zwischen 11 und 12 anstehende Grundspannung ist. Dies hat zur Folge, daß der Ausgang des Operationsverstärkers 14 bei Anstehen von Gleichstrom negativ, bei Wechselstrom jedoch positiv ist, während am Operationsverstärker 13 der Ausgang bei Gleichstrom positiv und bei Wechselstrom negativ ist. Den Eingangswiderständen 24, 26, 28, 30 sind zweite Eingangswiderstände 23, 25, 27, 29 mit weiteren Dioden 31, 34, 37 und 40 parallel geschaltet. Der Ausgang des Operationsverstärkers 13, der bei Anstehen von Wechselstrom negativ ist, liegt über die Dioden 32 bzw. 35 an den Anoden der Dioden 31 und 34. Entsprechend liegt der Ausgang des Operationsverstärkers 14, der bei Gleichstrom negativ ist, über die Dioden 38 und 41 an den Anoden der Dioden 37 und 40.

Eine ordnungsgemäße Funktion der Schaltung sei an folgendem Beispiel beschrieben. Hochspannungsseitig stehen 1000 Volt Wechselspannung an. Demgemäß liegt an der Klemme 1 die positive Meßspannung und über den Widerstand 24, 33 und 16 fließt ein Strom. Der von diesem Strom an dem Prüfwiderstand 16 verursachte Spannungsabfall liegt in der Höhe zwischen den beiden Referenzspannungen, so daß die Ausgänge der Operationsverstärker 18 und 19 negativ sind und über das Relais 17 kein Strom fließt. Gleichzeitig steht bei 15 eine Spannung an, die positiver ist als die Grundspannung, die zwischen den Widerständen 11 und 12 abgegriffen wird. Damit ist der Ausgang des Operationsverstärkers 13 negativ und der über den Widerstand 23 fließende Teil des von der Meßspannung verursachten Stromes wird über die Diode 32 abgeleitet, da das Kathodenpotential an der Diode 31 aufgrund des Spannungabfalls am Prüfwiderstand 16 positiver ist als das der Diode 32.

Führt nun keine der Klemmen 1 bis 4 Spannung und ist somit kein funktionsgemäßer Schaltzustand erreicht worden, dann fließt auch über den Prüfwiderstand 16 kein Strom. Der invertierende Eingang − des Operationsverstärkers 18, der mit einem Minuszeichen versehen ist, wird negativ gegenüber dem nicht invertierenden Engang +. Damit wird der Ausgang des Operationsverstärkers 18 positiv, und über die Diode 20 und den Kontakt 22 wird das Relais 17 erregt. Der Kontakt 22 ist als weitere Sicherung nur dann geschlossen, wenn am Eingang der Spannungswähleinrichtung überhaupt Spannung anliegt. Mit Hilfe des Relais 17 kann dann beispielsweise ein Signal eingeschaltet oder der Steuerkreis für einen Hochspannungsleistungsschutz unterbrochen werden. Führen zwei der Klemmen 1 bis 4 Spannung, dann fließt durch den Prüfwiderstand 16 der doppelte Strom und die Spannung, die über den Prüfwiderstand 16 abfällt, wird entsprechend höher. Damit erfolgt am nicht invertierenden Eingang + des Operationsverstärkers 19 ein Potentialwechsel. Der Ausgang dieses Operationsverstärkers wird dann auf plus geschaltet und wiederum das Relais 17 über die Diode 21 und den Kontakt 22 erregt.

Wenn z. B. die Klemme 4 die Meßspannung führt, obwohl hochspannungsseitig Wechselstrom ansteht, fließen beide Teilströme durch die Widerstände 29 und 30 über die Dioden 40 und 42 und über den Widerstand 16, da wegen des positiven Ausgangs des Operationsverstärkers 14 der Strom durch den Widerstand 29 nicht über die Diode 41 abgeleitet werden kann. So fließt auch über den Prüfwiderstand 16 der doppelte Strom, und das Relais 17 wird betätigt. Entsprechendes gilt, wenn einer der Anschlüsse 1 oder 2 an der Meßspannung liegt, obgleich hochspannungsseitig Gleichstrom ansteht, weil der Ausgang des Operationsverstärkers dann positiv ist und ein Ableiten des Teilstromes über die Widerstände 23 bzw. 25 und die Dioden 32 bis 35 dann nicht mehr möglich ist.

Die Verwendung von Operationsverstärkern hat den Vorteil, daß diese zu viert als IC's erhältlich sind. Jedoch können sie auch durch Schmitt-Trigger ersetzt werden oder durch hochverstärkende Darlington-Transistoren.

**Patentansprüche**

1. Schaltung zum Überwachen des Zustandes einer elektrischen Schaltung, die nach zwei oder mehreren Parametern in mehrere diskrete Schaltungszustände überführt werden kann, dadurch gekennzeichnet, daß
mit Hilfe eines Spannungsteilers (8, 9, 10) zwei feste Referenzspannungen erzeugt werden,
für jeden diskreten Schaltzustand nach dem ersten Parameter eine für jeden Schaltzustand gleiche Meßspannung über einen für jeden Schaltzustand gesonderten, sonst aber gleichen ersten Eingangswiderstand (24, 26, 28, 30), eine erste Diode (33, 36, 39, 40) und einen für alle Schaltzustände gemeinsamen Prüfwiderstand (16) geführt wird,
die über dem Prüfwiderstand (16) abfallende und in der Höhe zwischen den Referenzspannungen liegende Meßspannung in einem Komparator mit den Referenzspannungen verglichen wird, der bei Über- bzw. Unterschreiten einer der Referenzspannungen ein Signal auslöst,
und daß für den zweiten und jeden weiteren für den diskreten Schaltzustand maßgeblichen Parameter jedem ersten Eingangswiderstand (24, 26, 28, 30) ein zweiter Eingangswiderstand (23, 25, 27, 29) über eine zweite Diode (31, 34, 37, 40) parallel geschaltet ist und daß
Mittel vorgesehen sind, die bei ordnungsgemäßen Anstehen der Parameter eine Ableitung des über den zweiten Eingangswiderstand (23, 25, 27, 29) geführten Teiles der Meßspannung bewirken.

2. Schaltung nach Anspruch 1, dadurch gekennzeichnet, daß der Komparator aus zwei Operationsverstärkern (18, 19) mit je einem invertierenden Eingang (−) besteht und daß die höhere Referenzspannung dem invertierenden Eingang (−) des ersten Operationsverstärkers (19), die niedrigere Referenzspannung dem nicht invertierenden Eingang (+) des zweiten Operationsverstärkers (18) und die Meßspannung den verbleibenden beiden Eingängen zugeführt wird und die Ausgänge der Operationsverstärker bei entsprechender Polarisierung das Signal auslösen.

3. Schaltung nach Anspruch 1 oder 2, dadurch gekennzeichnet, daß die Mittel zur Ableitung des über den zweiten Eingangswiderstand (23, 25, 27, 29) geführten Teiles der Meßspannung aus zwei weiteren Operationsverstärkern (13, 14) mit je einem invertierenden Eingang (−) bestehen, daß eine stabilisierte positive Grundspannung an den nicht invertierenden Eingang (+) des ersten weiteren Operationsverstärkers (31) und an den invertierenden Eingang (−) des zweiten weiteren Operationsverstärkers (14) gelegt ist und daß an den verbleibenden Eingängen der weiteren Operationsverstärkern (13, 14) eine Spannung liegt, die bei Anstehen eines Parameters negativer als die Grundspannung und bei Fehlen des Parameters oder Anstehen eines alternativen Parameters positiver als die Grundspannung ist.

4. Schaltung nach Anspruch 1 oder einem der folgenden Ansprüche, gekennzeichnet durch ihre Verwendung zur Überwachung der Gruppierung von Verbrauchern in Eisenbahnwagen mit Mehrspannungswähleinrichtungen, z. B. der Gruppierung von Heizelementen.

**Claims**

1. Circuit for monitoring the state of an electrical circuit which can be transformed, in accordance with two parameters or a plurality of parameters, into a plurality of discrete switching-states, characterised in that two fixed reference voltages are generated with the aid of a voltage divider (8, 9, 10), a measurement voltage for each discrete switching-state in accordance with the first parameter and having the same value for each switching-state, being led via a separate, but otherwise identical, first input-resistance (24, 26, 28, 30), a first diode (33, 36, 39, 40) and a test resistance (16) which is common for all switching-states, the said measurement voltage, dropping across the test resistance (16) and having a value between the reference voltages, being compared with the latter in a comparator, which triggers a signal whenever the measurement voltage falls below the lower reference voltage or exceeds the higher reference voltage, and that a second input-resistance (23, 25, 27, 29) for the second parameter defining the discrete switching-state, and for each additional such parameter, is connected in parallel to each first input-resistance (24, 26, 28, 30), via a second diode (31, 34, 37, 40), and that means are provided which, when the parameters are entered in the correct manner, effect tapping-off of that proportion of the measurement voltage which is led via the second inputresistance (23, 25, 27, 29).

2. Circuit according to Claim 1, characterised in that the comparator consists of two operational amplifiers (18, 19), each with one inverting input (−), and that the higher reference voltage is supplied to the inverting input (−) of the first operational amplifier (19), the lower reference voltage is supplied to the non-inverting input (+) of the second operational amplifier (18), and the measurement voltage ist fed to the remaining two inputs, and the outputs of the operational amplifiers trigger the signal when the polarisation is appropriate.

3. Circuit according to Claim 1 or 2, characterised in that the means for tapping-off that proportion of the measurement voltage which is led via the second input resistance (23, 25, 27, 29), consist of two additional operational amplifiers (13, 14), each with an inverting input (−), that a stabilised positive base voltage is applied to the non-inverting input (+) of the first additional operational amplifier (31) and to the inverting input (−) of the second additional operational amplifier (14), and that there is a voltage at the remaining inputs of the additional operational amplifiers (13, 14), which is more negative than the base voltage when a parameter is entered, and is more positive than the base voltage when the parameter is absent, or when an alternative parameter is entered.

4. Circuit according to Claim 1 or one of the following Claims, characterised by its use for monitoring the combination of consuming equipment in railway vehicles fitted with multiple-voltage selecting devices, for example the combination of heating-elements.

## Revendications

1. Circuit pour la surveillance d'un branchement électrique qui peut être amené dans plusieurs états de commutation discrets selon deux ou plusieurs paramètres, circuit caractérisé en ce que deux tensions de référence fixes sont obtenues à l'aide d'un diviseur de tensions (8, 9, 10), tandis que pour chaque état discret selon le premier paramètre une tension de mesure identique pour chaque état est acheminée par l'intermédiaire d'une résistance d'entrée spécialisée pour chaque état mais par ailleurs identique (24, 26, 28, 30), d'une première diode (33, 36, 39, 40), et d'une résistance de contrôle (16) commune pour tous les états, la tension de contrôle se manifestant aux bornes de la résistance de contrôle (16) et dont le niveau se situe entre les tensions de références, étant comparée dans un comparateur (18, 19) avec les tensions de références et déclenchant un signal lorsqu'elle franchit vers le haut ou vers le bas l'une des tensions de références, tandis que pour le second paramètre et pour chaque autre paramètre déterminant un état discret, une seconde résistance d'entrée (23, 25, 27, 29) est branchée en parallèle par l'intermédiaire d'une seconde diode (31, 34, 37, 40) sur chacune des premières résistances d'entrée (24, 26, 28, 30), des moyens étant prévus qui lorsque les paramètres sont corrects déterminent une dérivation de la fraction de la tension de mesure acheminée par l'intermédiaire de la seconde résistance d'entrée (23, 25, 27, 29).

2. Circuit selon la revendication 1, caractérisé en ce que le comparateur (18, 19) est constitué de deux amplificateurs opérationnels comportant chacun une entrée inversante (−), la tension de référence la plus élevée étant appliquée à l'entrée inversante (−) du premier amplificateur opérationnel (19), la tension de référence la plus basse étant appliquée à l'entrée non inversante (+) du second amplificateur opérationnel (18) et la tension de contrôle étant appliquée aux deux entrées restantes, tandis que les sorties des amplificateurs opérationnels délivrent le signal avec une polarisation convenable.

3. Circuit selon l'une quelconque des revendications 1 et 2, caractérisé en ce que les moyens pour dériver la fraction de la tension de mesure acheminée par l'intermédiaire de la seconde résistance d'entrée (23, 25, 27, 29) sont constitués de deux autres amplificateurs opérationnels (13, 14) comportant chacun une entrée inversante (−), une tension de base positive stabilisée étant appliquée à l'entrée non inversante (+) du premier (13) de ces autres amplificateurs opérationnels et à l'entrée inversante (−) du second (14) de ces autres amplificateurs opérationnels, tandis qu'aux entrées restantes de ces autres amplificateurs opérationnels (13, 14) est appliquée une tension qui lorsque la présence d'un paramètre est plus négative que la tension de base et qui en l'absence de ce paramètre ou la présence d'un autre paramètre est plus positive que la tension de base.

4. Circuit selon l'une quelconque des revendications 1 à 3, caractérisé en ce qu'il est appliqué à la surveillance du groupage des appareils d'utilisateurs dans les wagons de chemin de fer avec des dispositifs de sélection multi-tensions par exemple le groupage d'éléments chauffants.